Europäisches Patentamt

(19) European Patent Office ,

Office européen des brevets

(11) Publication number: **0 055 551**
**A2**

(12) **EUROPEAN PATENT APPLICATION**

(21) Application number: **81305914.4**

(22) Date of filing: **17.12.81**

(51) Int. Cl.³: **G 11 C 17/00**

(30) Priority: **25.12.80 JP 184562/80**

(43) Date of publication of application:
**07.07.82 Bulletin 82/27**

(84) Designated Contracting States:
**DE FR GB NL**

(71) Applicant: **FUJITSU LIMITED**
**1015, Kamikodanaka Nakahara-ku**
**Kawasaki-shi Kanagawa 211(JP)**

(72) Inventor: **Koyama, Kazumi**
**1-5, Shin-asahigaoka**
**Ikoma-shi Nara 630-02(JP)**

(72) Inventor: **Fukushima, Toshitaka**
**1604-442, Shiomidai Isogo-ku**
**Yokohama-shi Kanagawa 235(JP)**

(72) Inventor: **Kawabata, Yuichi**
**42-402, Minamihiyoshidanchi 1238, Hyoshihoncho**
**Kohoku-ku Yokohama-shi Kanagawa 223(JP)**

(74) Representative: **Sunderland, James Harry et al,**
**HASELTINE LAKE & CO Hazlitt House 28 Southampton**
**Buildings Chancery Lane**
**London WC2A 1AT(GB)**

(54) **Output buffer circuit.**

(57) The output buffer circuit is capable of taking three output states, high level, low level and high impedance.

The buffer circuit includes a detector circuit (Zener diode $D_3$, resistors $R_5$ and $R_6$, and transistor $Q_5$) for detecting power source voltage (Vcc) applied to the buffer circuit. When the power source voltage becomes high (e.g. 7V) the detector circuit ($D_3$, $R_5$, $R_6$, $Q_5$) switches the buffer circuit to high impedance output state (diode $D_3$ is turned ON, so that transistor $Q_5$ is turned ON to connect the collector of a transistor $Q_2$ to ground G and to turn the output stage transistors $Q_3$, $Q_2$, $Q_4$ OFF).

Fig. 6

# OUTPUT BUFFER CIRCUIT

The present invention relates to an output buffer circuit.

Output buffer circuits for PROM devices have been previously proposed.

Figure 1 of the accompanying drawings is a schematic block diagram of a conventional bipolar 4K-bit PROM device,

Figure 2 of the accompanying drawings is a more detailed circuit diagram of a part of the PROM of Figure 1,

Figure 3 is a circuit diagram showing an equivalent circuit of a transistor cell used in the memory cell array of the PROM of Figures 1 and 2, and

Figure 4 is a circuit diagram of an output buffer employed in the PROM of Figures 1 and 2.

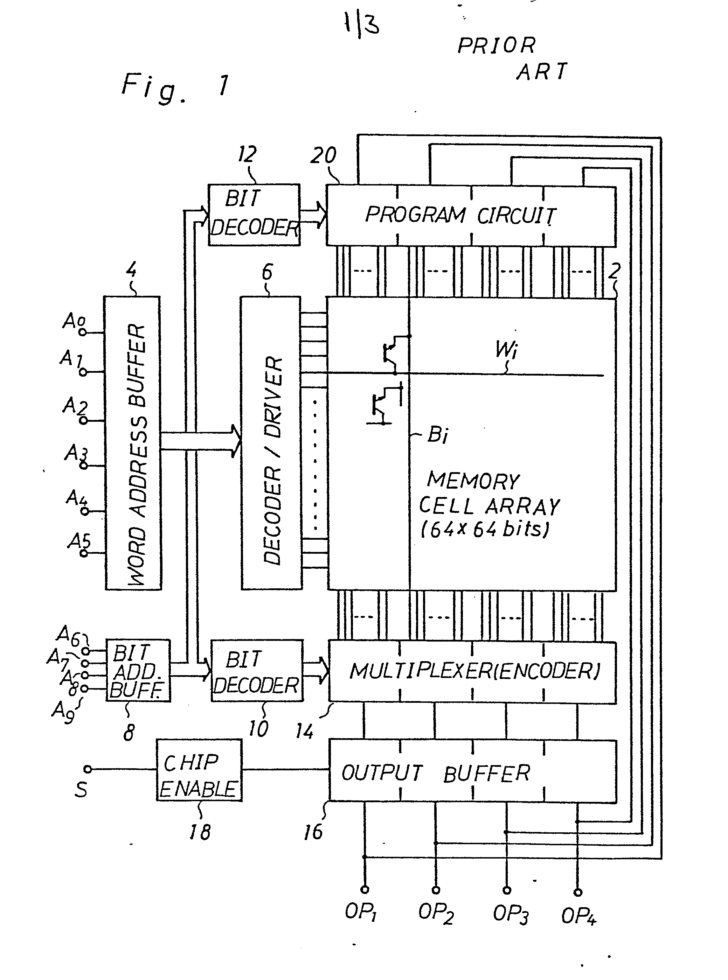

As shown in Figure 1, a conventional bipolar 4K-bit PROM device comprises a memory cell array 2 composed of 4096 memory cells disposed in a matrix of 64 rows and 64 columns. Each of the memory cells is constituted by, for example, an open-base type transistor which is equivalent to a series connection of two diodes of opposite polarities (a back-to-back connection of diodes). Writing-in of information into such a memory cell is effected by bringing one of the PN junctions of the cell into a short-circuit condition as a result of the supply of a large writing -in current. A word address buffer, or word address inverters, 4 amplify and invert input word address

signals $A_0$ to $A_5$, and a word address decoder/driver 6 decodes word address signals from the word address buffer 4 and applies the decoded word address signals to the memory cell array 2. A bit address buffer, or bit address inverters, 8 amplify and invert input bit address signals $A_6$ to $A_9$, and apply bit address signals output therefrom to a bit address decoder 10 connected to a multiplexer 14 and a bit address decoder 12 connected to a program circuit 20.

For read-out, the decoder 10 decodes output bit address signals from the bit address buffer 8 and applies the decoded bit address signals (bit selection signals for read-out) to the multiplexer 14. The multiplexer 14 reads out information from the memory cells connected between the word line selected by the above-mentioned word address decoder/driver 6, and the bit lines selected by the bit address decoder 10. An output buffer 16 amplifies the read-out signals from the multiplexer 14, and applies the amplified read-out signals to output terminals $OP_1$ to $OP_4$. The output buffer 16 is enabled by a chip enable circuit 18 which receives an input chip enable signal.

For write-in, the decoder 12 decodes the output bit address signals from the bit address buffer 8 and applies the decoded bit address signals (bit address signals for writing-in ) to the program circuit 20. The program circuit 20 writes information into the memory cells connected between the word line selected by the word address decoder/driver 6 and the bit lines selected by the bit address decoder 12.

The reading out of information from the above-mentioned PROM is effected by applying the 6-bit word address signals $A_0$ to $A_5$ to the word address buffer 4, the 4-bit bit address signals $A_6$ to $A_9$ to the bit address buffer 8, and a low level signal to the chip enable circuit 18. Four bits of information, from the selected memory cells, appear at the output terminals $OP_1$ to $OP_4$, through the multiplexer 14 and the output buffer 16.

The writing-in of information to the PROM is effected by applying the 6-bit word address signals $A_0$ to $A_5$ to the word address buffer 4, the 4-bit bit address signals $A_6$ to $A_9$ to the bit address buffer 8, and a high level signal to the chip enable circuit 18. 4-bit data signals to be written-in are applied to the output terminals $OP_1$ to $OP_4$ of the PROM device. In this case, the output buffer 16 is cut off from the output terminals $OP_1$ to $OP_4$ as a result of the application of the high level signal to the chip enable circuit 18. Therefore, data signals to be written-in pass from the output terminals to the program circuit 20, and writing-in of information, corresponding to the data signals , into the selected memory cells is effected.

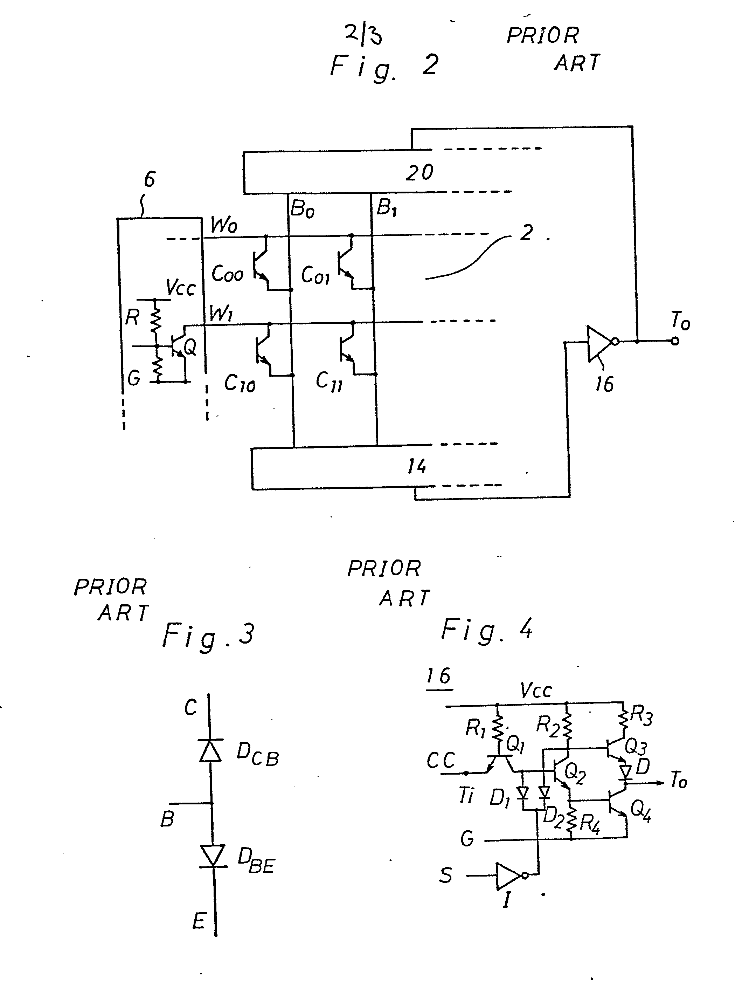

The writing-in operation will be described in more detail. As shown in Figure 2, for example, the PROM comprises memory cells $C_{00}$, $C_{01}$,..., each consisting of a bipolar transistor connected between a word line and a bit line (at a crossing point of a word line $W_0, W_1, \ldots$ and a bit line $B_0$ , $B_1 \ldots$) with its base not connected.

Writing is carried out thus : a large writing-in current, about 120 mA, is applied to a terminal which serves as a read output terminal and as a program (or write) terminal ; one of the bit lines e.g. bit line $B_0$ is selected by the program circuit 20 and to the selected bit line $B_0$ writing -in current is applied, one of the word lines e.g. word line $W_1$ is selected by the word address decoder /driver 6 and the selected word line $W_1$ is made to take a low level ; and thereby writing-in current is applied to the selected memory cell e.g. cell

$C_{10}$. When writing is carried out as described above, the base-emitter connection of cell $C_{10}$ is broken down and assumes a short-circuit condition so that only the base-collector connection of cell $C_{10}$ acts equivalently to a forward direction (forward biassed ) diode. In the case of cells to which such writing-in current is not applied, the base-emitter connection of each cell serves as a reverse polarity (reverse biassed) diode in the circuit and current is therefore not allowed to flow in that cell even if read voltage (Vcc) of about 5V is applied between the bit and word lines at the crossing point of which the cell is formed. In the case of cells to which writing-in current has been applied, current is allowed to flow. In accordance with such ON and OFF conditions for passage of current, information "1" and "0" is stored.

The transistor of cell $C_{10}$ can be described as a series connection of two diodes, $D_{CB}$ and $D_{BE}$, as shown in Figure 3. The respective anodes of the diodes $D_{CB}$ and $D_{BE}$ are connected so as to correspond to the base of the transistor. The cathode of the diode $D_{CB}$ corresponds to the collector of the transistor and the cathode of the diode $D_{BE}$ corresponds to the emitter of the transistor. For write-in at cell $C_{10}$ of the PROM, the diode $D_{BE}$ is caused to break down and thus to be short-circuited.

Reading is carried out thus : read voltage (Vcc) is applied to a bit line selected by the multiplexer 14 ; a (selected) word line is grounded by the word address decoder/driver 6 through a transistor Q (Figure 2); and potential appearing on the bit line is applied through the multiplexer 14 to an output buffer 16. The potential appearing on the bit line is of high level when no writing has been effected at the selected cell and is of low level when writing has been effected at that cell. These levels serve as read outputs.

The output buffer 16 is an amplifier which generates a read output in response to the potential appearing at a bit line at the time of reading. The output section of output buffer 16 is of a three-state type so that problems do not arise upon the application of a high writing-in current to its output terminal at the time of programming.

As shown in Figure 4, this output buffer 16 comprises an input stage transistor $Q_1$, a phase splitting transistor $Q_2$, output stage transistors $Q_3$ and $Q_4$, resistors $R_1$ to $R_4$, and a diode D. The output stage of the output buffer is of a three-output (three state) type in a totem pole arrangement. In place of the transistor $Q_3$ and the diode D , a Darlington connection of transistors (a Darlington pair) may alternatively be used.

Ti is an input terminal connected to the multiplexer 14. If potential appearing at a relevant bit line is low in level, current is not allowed to flow into the collector side of transistor $Q_1$ but is allowed to flow to the emitter side of transistor $Q_1$, so that the transistor $Q_2$ is turned OFF with the transistor $Q_3$ ON but the transistor $Q_4$ OFF and the output of terminal To is made high level. On the other hand, if potential appearing at the bit line is high in level, current is allowed to flow to the collector side of transistor $Q_1$, so that the transistor $Q_2$ is turned ON with $Q_3$ OFF but $Q_4$ ON and the output of the terminal To is made low level. Above, it has been assumed that the output of inverter I is high level. However, when the output of the inverter I is made low level, the base and collector of transistor $Q_2$ become of low level through diodes $D_1$ and $D_2$, so that all of transistors $Q_2$, $Q_3$ and $Q_4$ are turned OFF and the output terminal To is turned to high impedance (Z) state.

-6-

In Figure 4, the diodes $D_1$ and $D_2$ may be replaced by PNP-transistors whose bases are connected to the output of the inverter I, whose collectors are connected to the base and collector of the phase splitting transistor $Q_2$, and whose emitters are connected to ground. Even if writing-in current is supplied to the terminal To when that terminal is in a high impedance (Z) state, the problem of this writing-in current being shorted to ground or Vcc level (the problem of high voltage associated therewith being clamped to ground or $V_{cc}$) by output stage elements of output buffer 16 does not arise.

For the purpose of making this output buffer take a high Z state, it is necessary that a signal S be applied to the input terminal of inverter I to make its output of low level. Further, when writing operation ceases and reading operation begins, it is necessary that the signal S be changed to make the inverter output high level .

Further, in this three-output-state circuit, both output state transistors $Q_3$ and $Q_4$ can be turned ON, causing a large amount of current to be wasted, and sometimes causing failure of the output stage transistors. When the amplitude of an input signal e.g. the potential appearing at a bit line, is made small, (with the intention of achieving high speed operation) and power source voltage (Vcc) changes in this case so as particularly to become high, for example, the input state transistor $Q_1$ allows current to flow to both emitter and collector sides thereof, so that the phase splitting tansistor $Q_2$ is incompletely turned ON and both of transistors $Q_3$ and $Q_4$ are turned ON, thus more readily causing failure of the output stage transistors.

According to the present invention there is provided an output buffer circuit capable of taking any of three output states, high level, low level and high impedance, characterised in that a detector circuit is provided therein which is operable to detect an increase of power source voltage applied to the buffer circuit and to switch the buffer circuit output state to the high impedance state in response to such detection.

An embodiment of the present invention can eliminate the above-mentioned problem and avoid break-down of output stage transistors of an output buffer, in particular, when the power source voltage Vcc becomes high, by the provision in the output buffer of a circuit for detecting a change of power source voltage Vcc, that is, for detecting a state in which power source voltage Vcc becomes high, to cause the output state to become a high Z state.

When provided with such a circuit, the output buffer can be automatically made to assume a high Z state in response to power source voltage Vcc applied at the time when writing is effected in a PROM, for example. That is, referring to Figure 2, a circuit which brings word lines to ground level at a time of writing comprises a transistor Q, a resistor R for supplying base current to the transistor Q, and the like. At the time of writing a large amount of base current must be supplied to the transistor Q, because a large amount of current must be passed through that transistor, whilst at the time of reading that base current must be limited because in this case the transistor Q functions as a signal control transistor. In order to achieve this adjustment, the voltage of the power source Vcc connected to the resistor R is changed from 5V at the time of reading to 7V, for example, at the time of writing.(externally supplied Vcc is changed in this fashion externally). Vcc is supplied in common to all circuits arranged on a PROM chip and thus power source voltage Vcc for the output buffer changes from 5V to 7V accordingly. When provided with a Vcc responsive circuit, the output buffer can therefore automatically be made to take a high Z state by the change of Vcc involved in a write operation. In the case in which power source voltage Vcc is increased by some other cause, when the output buffer is in operation for reading, then also the output of the output buffer also achieves a high Z state, thus preventing output stage transistors ($Q_3$ and $Q_4$, for example) from becoming conductive simultaneously.

Reference is made, by way of example, to the accompanying drawings, in which:-

Figure 1 is a schematic block diagram of a conventional bipolar 4K-bit PROM device,

Figure 2 is a more detailed circuit diagram of a part of the PROM of Figure 1,

Figure 3 is a circuit diagram showing an equivalent circuit of a transistor cell used in the memory cell array of the PROM of Figures 1 and 2,

Figure 4 is a circuit diagram of an output buffer employed in the PROM of Figures 1 and 2,

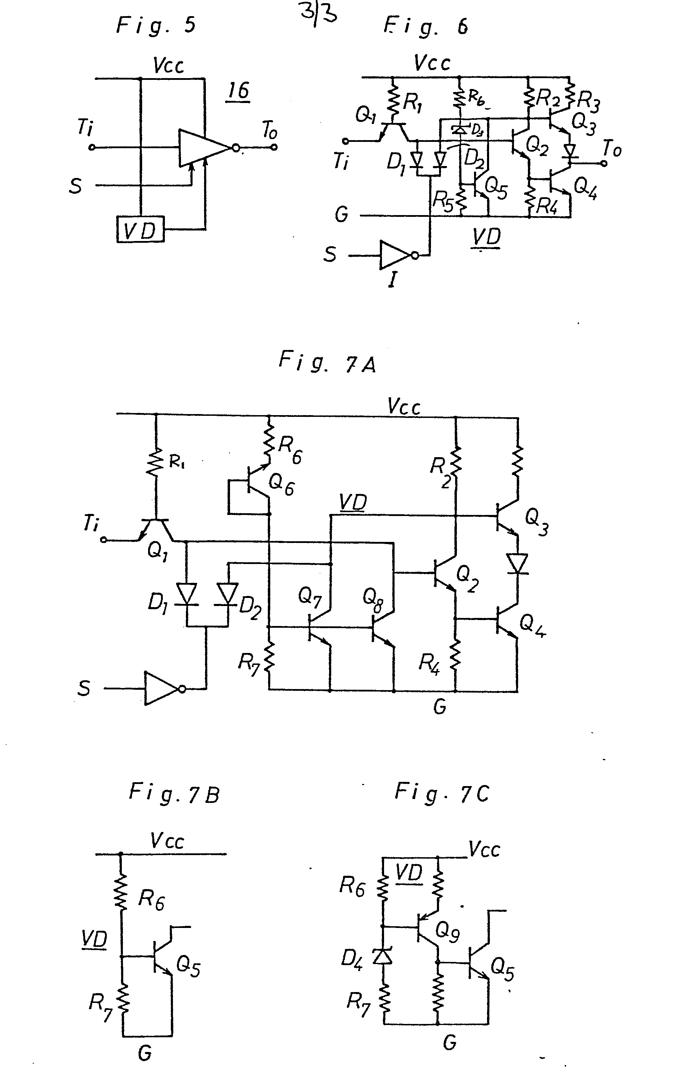

Figure 5 is a schematic block diagram of an embodiment of the present invention,

Figure 6 is a circuit diagram of an embodiment of the present invention ,

Figure 7A is a circuit diagram of another embodiment of the present invention, and

Figures 7B and 7C are circuit diagrams of parts of modified embodiments of the present invention.

The output buffer 16 of Figure 5 is basically an inverter and is therefore represented by the symbol for an inverter in that Figure. VD is a circuit for detecting change in power source voltage which comprises a Zener diode $D_3$, resistors $R_5$ and $R_6$ and a transistor $Q_5$, as shown in Figure 6. When power source voltage Vcc applied to the circuit of Figure 6 rises, the Zener diode $D_3$ is turned ON, so that the transistor $Q_5$ is turned ON to connect the collector/transistor $Q_2$ to ground G and to turn transistors $Q_3$, $Q_2$ and $Q_4$ OFF. The whole of the circuit will now be further described below.

If the input terminal Ti is of high level when power source Vcc is 5V, which is the voltage at the time of reading operations, and the input to the inverter is of low level, transistors $Q_2$ and $Q_4$ are turned ON, with the transistor $Q_3$ OFF, and an output of low level is applied to the terminal To. If the input terminal Ti is of low level, transistors $Q_2$ and $Q_4$ are turned OFF, with the transistor $Q_3$ ON, and an output of high level is applied to the terminal To. If the input of the inverter I takes a high level at this time, the output of the inverter I becomes low level, so that bases of transistors $Q_2$ and $Q_3$ become low level thereby to turn off all of transistors $Q_2$, $Q_3$ and $Q_4$. Namely, output To is turned to a high Z state.

When power source voltage is in the writing state, that is, 7V, the detector circuit detects the change of power source voltage , causing the transistor $Q_5$ to be

-10-

turned ON to connect the base of transistor $Q_3$ and the collector of transistor $Q_2$ to ground. As a result, all of transistors $Q_2$, $Q_3$ and $Q_4$ are turned OFF, bringing the output terminal To into the high Z state. High Z state is achieved independently of the output level of inverter I.

Table I below shows the relationship between levels of input terminal Ti, levels of input S to the inverter I, power source voltage Vcc and output level To.

### Table I

| Ti | S | Vcc | To |
|---|---|---|---|
| H level | L level | 5V | L level |
| L " | L " | 5V | H " |
| H " | H " | 5V | High Z |
| L " | H " | 5V | High Z |
| H " | L " | 7V | High Z |
| L " | L " | 7V | High Z |
| H " | H " | 7V | High Z |
| L " | H " | 7V | High Z |

As is apparent from Table I, the terminal To is of low level when power source voltage Vcc is 5V , inverter input is of low level and input terminal Ti is of high level. To is of high level when power source voltage Vcc is 5V, inverter input is of low level and the input terminal Ti is of low level. However, To is always high Z under other conditions.

The transistors $Q_5$ may be of such type as to connect the output terminal of invertor I to ground G unless the inverter I is broken even if output of inverter I is connected to ground G. The inverter I may be omitted in a case in which the terminal To is switched to high Z state only at the time of writing.

Figures 7A to 7C show modified forms of output buffer circuits embodying the present invention.

The detector circuit for detecting a change of power source voltage shown in Figure 7A comprises transistors $Q_6$ to $Q_8$ and Resistors $R_6$ and $R_7$. When power source voltage Vcc increases, the emitter-base connection of transistor $Q_6$ is broken down and base current is supplied to transistors $Q_7$ and $Q_8$, which are turned ON to connect the base and collector of transistor $Q_2$ to ground.

In Figure 7B, power source voltage Vcc divided by resistors $R_6$ and $R_7$ is applied to the base of transistor $Q_5$, and when Vcc increases, the voltage divided by resistors $R_6$ and $R_7$ also increases thereby to turn the transistor $Q_5$ ON.

In Figure 7C, an amplifying transistor $Q_9$ is provided in a detector circuit for voltage Vcc comprising resistors $R_6$, $R_7$, a Zener diode $D_4$, and a transistor $Q_5$. The Zener diode $D_4$ may be omitted. The collector of the transistor $Q_5$, in both Figures 7B and 7C, is connected to the base of the transistor $Q_3$ shown in Figure 6.

An embodiment of the present invention provides an output buffer, capable of taking three output states, in which a circuit is provided which ensures that the buffer takes a high Z state in correspondence with an increase in power source voltage. Thereby, output stage transistors can be protected and the output buffer can immediately be switched to high Z state by an increase in power source voltage at a time at which writing is effected,

-12-

when an embodiment of the present invention is applied to a PROM or a field programmable device.

An embodiment of the present invention provides an output buffer circuit capable of taking three output states, high and low level output states and a high impedance output state. The output buffer circuit includes a detector circuit for detecting when the power source voltage for the buffer circuit becomes particularly high, and for switching the output of the buffer circuit to the high impedance state in that event.

## CLAIMS

1.      An output buffer circuit capable of taking any
of three output states, high level, low level and high
impedance, characterised in that a detector circuit is
provided therein which is operable to detect an
increase of power source voltage applied to the buffer
circuit, when the circuit is in use, and to switch the
buffer circuit output state to the high impedance state
in response to such detection.

2.      A circuit as claimed in claim 1, further comprising
a control circuit operable to switch the buffer circuit
output state to the high impedance state in response to
an input signal applied to the buffer circuit.

3.      A circuit as claimed in claim 1 or 2, including
a phase splitting transistor and a first and second output
stage transistors connected in series, the emitter of the
phase splitting transistor being connected to the base of
the second output stage transistor, the collector of the
phase splitting transistor being connected to the base
of the first output stage transistor the emitter of
which is connected to the collector of the second output
stage transistor, the emitter of the second output stage
transistor being earthed when the output buffer circuit is
in use, and the collectors of the phase splitting transistor
and the first output stage transistor being arranged to
be supplied from the power source voltage line when the
output buffer circuit is in use.

4.      A circuit as claimed in claim 3, wherein an
output of the detector circuit is connected to the
collector of the phase splitting transistor.

5.      A circuit as claimed in claim 3 or 4, wherein
the detector circuit comprises a Zener diode, first and
second resistors and a transistor, the cathode of the

-14-

Zener diode being arranged for connection to the power
source voltage line, via the first resistor, when the
output buffer circuit is in use, and the anode thereof
being connected to the base of the said transistor of the
detector circuit to which base is connected one end of
the second resistor the other end of which is earthed when
the output buffer circuit is in use, the collector of the
said transistor of the detector circuit being connected
to the collector of the phase splitting transistor, and
the emitter of the said transistor of the detector circuit
being earthed when the output buffer circuit is in use.

6.      A circuit as claimed in claim 3 or 4, wherein the
detector circuit comprises a first transistor whose base
and collector are connected together, second and third
transistors the emitters of which are earthed when the
output buffer circuit is in use, a first resistor one end
of which is arranged for connection to said power source
voltage line when the output buffer circuit is in use,
and a second resistor one end of which is earthed when
the output buffer circuit is in use, the other end of the
first resistor being connected to the emitter of the first
transistor, the other end of the second resistor and the
bases of the second and third transistors being connected
to the collector of the first transistor, and the collectors
ofthe second and third transistors being respectively
connected to the collector and the base of the phase
splitting transistor.

7.      A circuit as claimed in claim 3 or 4, wherein the
detector circuit comprises the first resistor, one end of
which is arranged for connection to the power source voltage
line when the output buffer circuit is in use, a second
resistor one end of which is earthed when the output buffer
circuit is in use, and a transistor whose emitter is earthed when the output buffer circuit is in use, the other ends of the first and second resistors being connected to the base of the said transistor of the detector circuit, and the collector of the said transistor of the detector circuit being connected to the collector of the phase splitting transistor.

8.      A circuit as claimed in claim 3 or 4, wherein the detector circuit comprises first and second resistors each having one end arranged for connection to the power source voltage line when the output buffer circuit is in use, third and fourth resistors each having one end earthed when the output buffer circuit is in use, a Zener diode, a PNP-transistor, and an NPN-transistor whose emitter is earthed when the output buffer circuit is in use, the other end of the first resistor, the cathode of the Zener diode and the base of the PNP-transistor being connected together, the anode of the Zener diode being connected to the other end of the third resistor, the other end of the second resistor being connected to the emitter of the PNP-transistor, the collector of the PNP-transistor, the base of the NPN-transistor and the other end of the fourth resistor being connected together, and the collector of the NPN-transistor being connected to the collector of the phase splitting transistor.

9.      A circuit as claimed in claim 2, or as claimed in any one of claims 3 to 8 when read as appended to claim 2, wherein the control circuit comprises an inverter or buffer and first and second diodes, cathodes of the first and second diodes being connected to the output of the inverter of the buffer, and anodes of the first and second diodes being connected respectively to the base and collector of the phase splitting transistor.

10.     A memory device, including an output buffer circuit as claimed in any preceding claim.

Fig. 1

Fig. 2

PRIOR
ART

Fig. 3

PRIOR
ART

Fig. 4

0055551

3/3

Fig. 5

Fig. 6

Fig. 7A

Fig. 7B

Fig. 7C